(19) Europäisches Patentamt European Patent Office Office européen des brevets

(11) **EP 3 033 822 B1**

(12) **EUROPEAN PATENT SPECIFICATION**

(45) Date of publication and mention
of the grant of the patent:
**31.03.2021   Bulletin 2021/13**

(21) Application number: **14750622.4**

(22) Date of filing: **08.08.2014**

(51) Int Cl.:
*H02J 13/00* (2006.01)   *G01R 19/25* (2006.01)

(86) International application number:
**PCT/GB2014/052432**

(87) International publication number:
**WO 2015/022501 (19.02.2015 Gazette 2015/07)**

(54) **POWER SYSTEM CONTROL**

LEISTUNGSSYSTEMSTEUERUNG

COMMANDE DE RÉSEAUX ÉLECTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.08.2013   GB 201314611**

(43) Date of publication of application:
**22.06.2016   Bulletin 2016/25**

(73) Proprietor: **The University Of Birmingham Birmingham B15 2TT (GB)**

(72) Inventors:
• **ZHANG, Xiao-Ping**
  **Solihull**
  **West Midlands B91 3PH (GB)**
• **YANG, Xuan**
  **Xi'an City**
  **Shaanxi 710082 (CN)**

(74) Representative: **Somervell, Thomas Richard Marks & Clerk LLP**
  **Alpha Tower**
  **Suffolk Street**
  **Queensway**
  **Birmingham B1 1TT (GB)**

(56) References cited:
**WO-A1-2010/115474**

• **YU K K C ET AL: "An Approximate Method for Transient State Estimation", IEEE TRANSACTIONS ON POWER DELIVERY, IEEE SERVICE CENTER, NEW YORK, NY, US, vol. 10, no. 3, 1 July 2007 (2007-07-01), pages 1680-1687, XP011186641, ISSN: 0885-8977**
• **Michael Hurtgen ET AL: "Advantages of power system state estimation using Phasor Measurement Units", 16th PSCC, 18 July 2008 (2008-07-18), XP055040448, ISBN: 978-0-94-764928-9 Retrieved from the Internet: URL:http://www.pscc-central.org/uploads/tx _ethpublications/pscc2008_520.pdf[retrieved on 2012-10-09]**
• **RENKE HUANG ET AL: "Object-oriented 3-Phase distributed dynamic state estimator", POWER AND ENERGY SOCIETY GENERAL MEETING, 2011 IEEE, IEEE, 24 July 2011 (2011-07-24), pages 1-8, XP032055851, DOI: 10.1109/PES.2011.6039837 ISBN: 978-1-4577-1000-1**
• **YANG XUAN ET AL: "Coordinated algorithms for distributed state estimation with synchronized phasor measurements", APPLIED ENERGY, vol. 96, 20 December 2011 (2011-12-20), pages 253-260, XP028926123, ISSN: 0306-2619, DOI: 10.1016/J.APENERGY.2011.11.010**

## Description

### Field of the Invention

The present invention relates to an apparatus, a method and a computer program for the monitoring of power systems. More particularly the invention is concerned with the control of power flows and voltages of power systems in the event of a system disturbance.

### Background

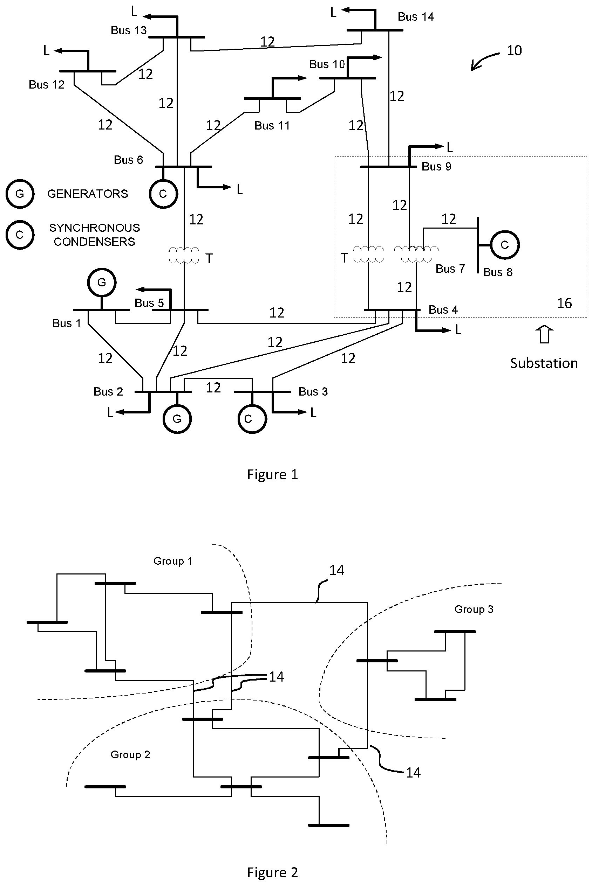

Power systems, or power grids, generally comprise multiple power buses interconnected by transmission lines. Figure 1 shows an example of an IEEE 14-bus system 10, in which the buses, Bus 1, Bus 2... Bus 14, are interconnected by transmission lines 12. Some buses, such as Bus 1 and Bus 2 have power supplied to them by generators G, while some buses have power drawn from them by loads, L. In addition some buses have synchronous condensers C, which are used to either generate or absorb energy as required to adjust the voltage or improve the power factor in the grid. Also, as shown in Figure 1, some transmission lines 12 may include transformers T for stepping down or stepping up the voltage between buses. As shown in Figure 1, the grid may include one or more substations 16. Substation 16 is shown to include buses 4, 7, 8 and 9 as well as the associated transmission lines 12 and transformers T between those buses.

Power systems are expected to operate in a steady state. However they almost always have to operate in transient conditions as well because system disturbances cannot be avoided. When system disturbances happen, the power flows, voltages and currents in the system can be changing extremely fast, and the power system may be unstable. In the event of rapid transient conditions, the control of power systems is necessary to make the systems stable. This control can be conducted by several control functions such as frequency stability control, voltage stability control, transient stability control, and system oscillations control, as well as power system component protection schemes and system wide automated protection schemes, called system integrity protection schemes (SIPS), and/or use FACTS (flexible AC transmission system) devices and/or HVDC (High Voltage DC) and/or HVDC Grids in modern power systems. The FACTS is generally a power electronics-based system, which is widely employed in modern industry to control power grids.

However, controlling large, complex grids is not a straightforward task. Before system control functions can be taken, estimates of the system status in terms of voltages and currents should be carried out to provide accurate snapshots. Using raw measurement systems would require an excessive number of measurement instruments/signals and processor demand. Therefore, power grid control functions make use of power system state estimation, which involves estimating the state of the grid from a more manageable number of measurements. A power system state estimator will provide an estimate of the voltage (and/or current) and phase angles at all of the system buses at a given point in time. This estimate can be used in the control functions of power systems.

State estimation in a grid for steady state or relatively slow changes in conditions has been widely applied in power grids. However, a problem arises when trying to perform state estimation during transient conditions, in particular rapid transient conditions, as can occur when there is a disturbance in the grid. During a system disturbance, when voltage and current waveforms are not sinusoidal (at the fundamental frequency of 50 or 60 Hz), state estimation methods for steady state are not effective or do not work at all. In these situations special transient state estimation is required.

One example of transient state estimation methods has been described by Zima-Bockarjova et al. in "Analysis of the State Estimation Performance in Transient Conditions. IEEE Trans. Power Syst.", 2011. 26(4): pp. 1866-1874. This proposes upgrading the normal state estimation procedure by adjusting for the system disturbance. However, non-sinusoidal voltage and current waveforms were not considered in this attempt, and thus this method cannot be used to deal effectively with state estimation during a system disturbance.

Another method has been proposed by Yu and Watson in "An Approximate Method for Transient State Estimation": IEEE Trans. Power Del., 2007. 22(3): pp 1680-1687. This is based on measurements of a single, very short time step. A problem with the method is that it places unacceptable requirements on the performance of the measuring instruments and data communication speed.

Another method for state estimation has bee proposed by RENKE HUANG ET AL: "Object-oriented 3-Phase distributed dynamic state estimator", POWER AND ENERGY SOCIETY GENERAL MEETING, 2011 IEEE, IEEE, 24 July 2011 (2011-07-24), pages 1-8, ISBN: 978-1-4577-1000-1.

The present invention seeks to alleviate the above problems.

### Summary

According to a first aspect of the present invention there is provided a method of controlling power flows and/or voltages in a power system according to claim 1. The method comprises monitoring conditions of voltage and/or current at a set of system locations for a scanning cycle of synchronised measurements. The scanning cycle comprises a series of time steps in which instantaneous sample measurements of voltage and/or current are taken. The monitoring provides data comprising the instantaneous sample measurements for a complete scanning cycle. A transient state estimation is determined based on the data for two or more sequential time steps. The transient state estimation includes an estimation of a non-sinusoidal voltage or current waveform caused by a disturbance to the power system. The method further includes forming a snapshot that includes instantaneous voltages, current flows and power flows of the power system. The method further includes making an adjustment to mitigate the effect of the disturbance. The adjustment may be an adjustment to an amount of power supplied to and/or drawn from the power system, and/or protecting the system by changing the system configuration.

The synchronised measurements may be provided by a number of time synchronised measurement instruments such as PMUs. The synchronised measurements can be obtained using a standard time signal as the reference, for example a Global Positioning System (GPS) time signal. The scanning cycle may be in accordance with the international standards of transmission data measured in electricity power grid operation and control.

Determining the transient state estimation may include determining an estimation at system locations other than the system locations used for the monitoring. The transient state estimation may be based on a state space model and a discretised model that includes a non-sinusoidal voltage or current waveform in the estimation.

The power system may comprise a plurality of interconnected buses, including one or more buses at which power can be supplied to the grid, and one or more buses at which power can be drawn from the grid, the method including adjusting an amount of power supplied to and/or drawn from one or more of the buses.

The method may further comprise dividing the power system into a plurality of subsystems, and each subsystem comprising one or more of the buses. Preferably, one or more of the subsystems comprises one or more substations, each substation including one or more buses, power transformers, switching devices such as circuit breakers or disconnectors to cut power, and wherein measurement, protection and control devices are physically located in the substation.

A non-overlapping approach may be used to divide the power system into the plurality of subsystems connected by tie-lines, the tie lines comprising transmission lines or transformers. A transient state estimation can be conducted for each subsystem individually taking synchronised measurements from the subsystem.

Preferably, the transient state estimations of each of the subsystems are aggregated to provide a transient state estimation of the whole grid. The aggregated transient state estimation may provide the snapshot including voltages, current flows and power flows of the whole power system, or of part of the power system.

The method may further comprise further comprising using the snapshot data in control functions or FACTS devices or HVDC systems to protect and control the power system.

The method may be implemented in a substation.

According to a second aspect of the invention there is provided a power system according to claim 11 comprising a plurality of synchronised measurement units at locations in the power system. Each measurement unit is configured to obtain sample data over a synchronised scanning cycle comprising a series of time steps in which instantaneous sample measurements of voltages and/or currents are taken, and to transmit the instantaneous sample data for a complete scanning cycle after completion of the cycle. A transient state estimator is configured to receive and analyse the sample data to determine a transient state estimation based on the data for two or more sequential time steps. The transient state estimation includes an estimation of a non-sinusoidal voltage or current waveform caused by a disturbance to the power system. At least one power device adjusts an amount of power supplied to and/or drawn from the power system to mitigate the effect of the disturbance.

The transient state estimator may be configured to analyse the sample data to provide transient state estimations for each of a plurality of subsystems that make up the whole power system, or part of the power system. The transient state estimator may be further configured to aggregate the transient state estimation for each of the subsystems to provide a transient state estimation for the whole power system, or part of the power system.

The power system may further comprise a system controller, the system controller configured to receive the transient state estimations and to control said at least one power device to mitigate the effect of the disturbance.

The system may provide an output to several control functions, such as frequency stability control, voltage stability control, transient stability control, system oscillations control, system component protection schemes, system wide automated protection schemes, and system integrity protection schemes (SIPS), or for use by FACTS devices and/or High Voltage DC (HVDC) and/or HVDC Grid to protect and control the power system.

It is an advantage that, by using synchronised measurements in a scanning cycle, the transient state estimation can be performed using the measurements of multiple steps in a single scanning cycle. Thereby, an accurate estimate of the state (e.g. voltage) at each bus in the grid can be made even for a non-sinusoidal waveform caused by a disturbance. Moreover, the data for measurements of multiple steps in each scanning cycle is transmitted to the state estimator after completion of the scanning cycle. This substantially reduces the communication burden, and allows for more accurate estimations by using shorter time steps in the scanning cycle. These functions have not hitherto been available in practical power system state estimators because the state estimation was not able to provide reliable estimates during non-sinusoidal disturbances.

With the aid of synchronised measurements, the invention is the first of its kind that can be implemented in power grids to perform state estimation in the transient condition while taking into account the communication requirements. The synchronised measurements from multiple remote measurement points on the power grid are synchronised by a common time source. The outputs of the state estimation can form a snapshot (voltage and/or current at all buses) of the power system during the transient condition, and this snapshot can be used in several control functions or FACTS devices to protect and control power grids.

With the development of power grids and massive integration of intermittent energy sources, as well as fast power electronic devices such as FACTS devices and HVDC grids, the estimated results during the period of a disturbance become extremely important and can be used for fast system protection and control functions. The analysis provides a snapshot (instantaneous voltage and/or current at buses) of the power system during the transient condition, and this snapshot can be used by control functions or FACTS devices to protect and control power grids. The results of the state estimator can be used to determine if any changes should be made (for example adjusting the voltage at any of the buses using a synchronous condenser) and provided for further control functions to make the grid stable or optimise the performance of the grid.

Brief Description of the Drawings

Figure 1 is a schematic illustration of a power grid for the example of an IEEE 14-bus system.
Figure 2 is a schematic illustration of a non-overlapping approach for decomposing a power grid.
Figure 3 is a simple function diagram of measurements made by a phasor measurement unit (PMU).
Figure 4 is a graph illustrating a relationship between PMU measurement samples in a scanning cycle and a sinusoidal waveform.
Figure 5 is an electrical wiring diagram of a typical single phase model of a lumped transmission line.
Figure 6 is schematic illustration showing the structure of a matrix of measurements as used in an embodiment of the invention.
Figure 7 is a graph showing the results of an example of a transient state estimation made in accordance with an embodiment of the invention.
Figure 8 is a graph showing discrepancies between actual and estimated values in the example transient state estimation of Figure 7.
Figure 9 is a block diagram illustrating the principal components of a power system employing a transient state estimator in accordance with embodiments of the invention.
Figure 10 is a flow chart illustrating the principal steps in a transient state estimation method in accordance with embodiments of the invention.

Detailed Description of Embodiments

The embodiments described below include practical methods for performing a transient state estimation of a power grid, which allow for accurate state estimation during a period of system disturbance. These include examples of transient state estimation of a grid of the type shown in Figure 1, but the methods are not limited to such examples and may be applied to a wide variety of grid configurations. Also, the embodiments describe the obtaining of synchronised measurements using phasor measurement units (PMUs). The synchronised measurements could be provided by a multitude of instruments. The PMU is one example currently being used in power grids. PMUs are devices which can provide synchronised measurements of the electrical waves with a common time source. However, any other known or yet to be developed devices that can provide synchronised measurement samples at a high sampling frequency could be employed.

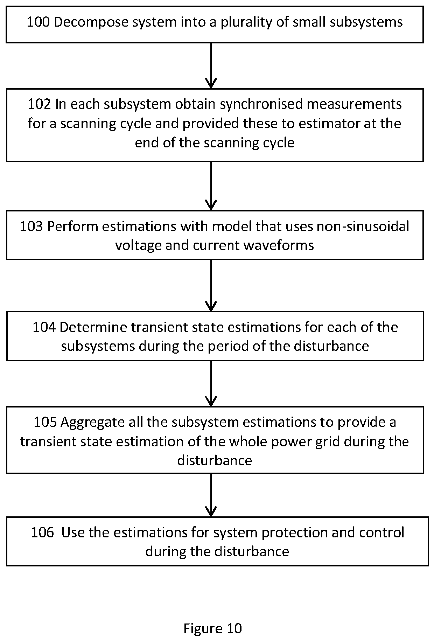

An overview of the procedure is shown in the flow diagram of Figure 10, and has the following steps:

1) Step 101. For a large grid, or system, it is preferred to decompose the grid into a multitude of small subsystems. The transient state estimation method is carried out for each subsystem individually. The procedure is thus referred to hereafter as a distributed space state estimation (DSSE);

2) Step 102. In each subsystem, multiple steps of synchronised measurements are obtained for one scanning cycle and these are provided to an estimator at the same time at the end of each scanning cycle;

3) Step 103. A model of the subsystem during the period of a disturbance is used to perform the estimation. The model is one that can use non-sinusoidal voltage and current waveforms in the estimation process;

4) Step 104. With the synchronised measurements of multiple steps in 2) and the estimation model in 3), transient state estimations are determined for each of the subsystems during the period of the disturbance;

5) Step 105. All the subsystem estimations are aggregated to provide a transient state estimation of the integrated system (i.e. the whole power grid) during the period of a disturbance. The transient state estimations of this integrated system provide snapshots of the state of the grid during the disturbance;

6) Step 106. The estimated results (snapshots) are transmitted to a system control function or FACTS device or HVDC or HVDC Grid for system protection and control directly during the period of a disturbance.

More detailed explanations and examples of each of steps 1) to 4) will now be considered.

1) Decomposing the Grid. The high sampling rate of phasor measurement units (like PMUs - see below) means there are more measurements that can be provided to the state estimator in transient conditions, but this places more demands on the equipment. Especially in a large grid, it is not practical to transmit all the raw sample data acquired by all the PMUs to a control center to perform a transient state estimation. In order to reduce the computing burden, memory storage and data exchange requirements, a distributed configuration is employed. Also, this distributed configuration introduces more flexibility, which is attractive for use in future "Smart Grids".

Figure 2 is a schematic illustration showing an example of decomposition of a power system, which employs a non-overlapping approach to split the power system into several subsystems - Group 1, Group 2, Group 3, by tie-lines 14. Gomez-Exposito et. al., in "A taxonomy of multi-area state estimation methods," Electric Power Systems Research, vol. 81, pp. 1060-1069, 2011, provide detailed information about the non-overlapping approach including the corresponding measurements and states. In this non-overlapping approach, several neighboring substations can form a DSSE group, so a large power system can be divided into many independent DSSE groups. An individual group is only affected by its neighboring groups via tie-lines 14. The method supposes that the mutual influence between groups is negligible, because the signals change too fast under the transient condition. Therefore, each DSSE group can be regarded as an independent system, and thus the transient state estimation in each group can be performed locally. Furthermore, the computing burden and hardware requirement are reduced.

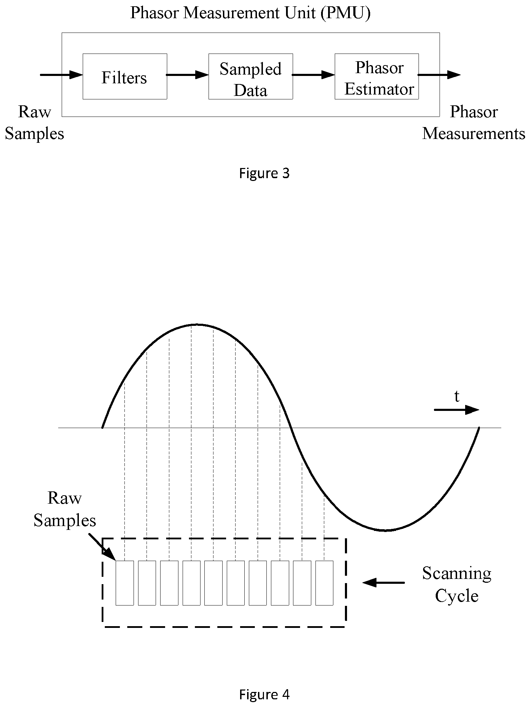

2) Obtaining Measurements. In this example, phasor measurement units (PMUs) are used to obtain the synchronised measurements on which the transient state estimations will be based. PMUs measure the raw samples of electrical waves (current and/or voltage) in a power grid. PMUs are devices which can provide synchronised measurements of the electrical waves with a common time source. PMUs can provide synchronous phasor measurements with GPS (Global Positioning System) time tags to the power system. Because of their high accuracy and sampling rate, PMU measurements are widely used for state estimation. In practice, PMUs provide phasor measurements, which are estimated from raw samples. These phasor measurements are composed of the magnitudes and the phase angles. The magnitudes are the Root Mean Square (RMS) values of the signal, and the phase angle is the angle between the reporting instant and the peak of the sinusoid. A simple function diagram of PMU measurements is illustrated in Figure 3.

The period during which every phasor measurement can be produced in PMUs is referred to as the scanning cycle. The relationship between the scanning cycle and raw samples in PMUs is illustrated in Figure 4.

Figure 4 illustrates the relationship between the samples and the synchronised measurements of a PMU for a waveform. The raw samples capture instantaneous magnitudes of signal in each time instant during a short period called a scanning cycle or reporting time. In every scanning cycle, a number of synchronised measurements at a number of discrete time steps are produced. The scanning cycle of a conventional Remote Terminal Unit (RTU) is 580ms under the frequency of 50Hz, which is too slow for a typical transient state estimation. On the other hand, according to the IEEE Std C37.118-2011, the scanning cycle of synchronised measurements can be decreased to 10ms or even less if needed. Thus, the PMUs provide synchronised measurements with much higher sampling rates.

Note that each PMU phasor measurement is produced from a steady state sine wave under a fundamental frequency with time-invariant amplitude. However, under transient conditions, both the amplitude and the fundamental frequency become time-variant, so the objective signal cannot be treated as a sinusoid. Hence, the conventional phasor measurements (from PMUs) may not be suitable for transient state estimation.

In embodiments of the transient DSSE method described here, the instantaneous magnitudes of multiple samples (e.g. every sample) of each of the Synchronised Measurements (for instance, PMU measurements) are transmitted to the estimator instead of the phasor measurements. The instantaneous measurements consist of voltage and current. As is shown in Fig. 4, there are a number of samples in one scanning cycle, so the sampling rate of the instantaneous measurements is much higher than the phasor measurements. Also, all the instantaneous measurements in one scanning cycle are imported to the estimator at the same time (at the end of the scanning cycle). Hence, the time interval between two consecutive DSSE estimations is equal to the scanning cycle of the Synchronised Measurements (for instance, PMU measurements).

To ensure accuracy of the measurements used in the DSSE state estimations, it is important to ensure that the scanning cycles of all of the PMUs are synchronised. As previously mentioned, PMUs can provide synchronous phasor measurements with GPS time tags. Other operating parameters of the PMUs are the scanning cycle length and the number of samples per cycle. According to the IEEE Standard C37.118-2011, the scanning cycle of synchronised measurements can be decreased to 10ms or even less if needed. Based on the IEC 61850 standard, there are normally 80 samples in each scanning cycle. In the test case studies described below a scanning cycle of 5ms is used, leading to a time interval between measurement samples of 0.125ms.

The synchronised measurements from multiple remote measurement points on the power grid are synchronised by a common time source. The output of PMUs strategically located across a grid can be provided to a state estimator, which analyses the data to perform state estimation.

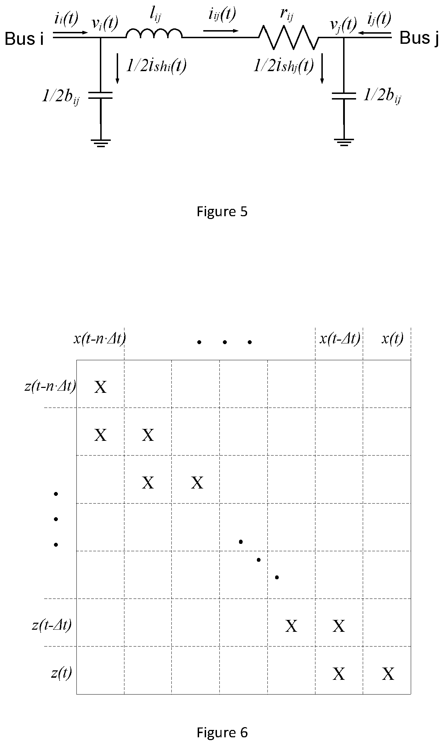

3) The Transient State Estimation Model. Traditional state estimation was established on the basis of a static model of the power system. However, for transient state estimation, a state space model is used. Figure 5 illustrates a typical single phase model of a lumped transmission line, as used in this example, for a power system in which a short segment of transmission line is represented by a coupled PI ($\pi$) model. The PI model as shown in Fig. 5 is a typical model used to represent a transmission line. In Figure 5: $l_{ij}$, $r_{ij}$ and $b_{ij}$ are the inductance, resistance and susceptance of branch $ij$, respectively; $v_i(t)$ and $v_j(t)$ are the instantaneous voltages at Buses $i$ and $j$ respectively; $i_i(t)$, $i_j(t)$, $i_{ij}(t)$, $i_{shi}(t)$ and $i_{shj}(t)$ represent the instantaneous values of the sending-end current, the receiving-end current, the branch current and the shunt current, respectively. The following equations are used for the state space model of branch $ij$ under transient conditions.

$$\frac{di_{ij}(t)}{dt} = \frac{1}{l_{ij}} \cdot (v_i(t) - v_j(t) - r_{ij} \cdot i_{ij}(t)) \tag{1}$$

$$\frac{dv_i(t)}{dt} = \frac{2}{b_{ij}} \cdot (i_i(t) - i_{ij}(t)) \tag{2}$$

$$\frac{dv_j(t)}{dt} = \frac{2}{b_{ij}} \cdot (i_{ij}(t) - i_j(t)) \tag{3}$$

*Discretised State Model*

Equations (1)-(3) above are the first order differential model of the branch current $i_{ij}$ and bus voltages $v_i$ and $v_j$. To transform these into a discrete state space model, the $dx/dt$ terms can be written in the following form:

$$\frac{dx(t)}{dt} \approx \frac{x(t) - x(t - \Delta t)}{\Delta t} \tag{4}$$

where:

$\Delta t$       is the interval time between two steps;
$x(t)$       signifies a variable at time $t$; and
$x(t-\Delta t)$       signifies the variable at time $t-\Delta t$.

The discrete state model in transient conditions can therefore be written as:

$$v_i(t) - v_j(t) = (r_{ij} + \frac{l_{ij}}{\Delta t}) \cdot i_{ij}(t) + \frac{l_{ij}}{\Delta t} \cdot i_{ij}(t - \Delta t) \tag{5}$$

$$i_i(t) = \frac{b_{ij}}{2 \cdot \Delta t} \cdot v_i(t) - \frac{b_{ij}}{2 \cdot \Delta t} \cdot v_i(t - \Delta t) + i_{ij}(t) \tag{6}$$

$$i_j(t) = -\frac{b_{ij}}{2 \cdot \Delta t} \cdot v_j(t) + \frac{b_{ij}}{2 \cdot \Delta t} \cdot v_j(t - \Delta t) + i_{ij}(t) \qquad (7)$$

Equations (5)-(7) show the relationships between the voltage and the current of branch $ij$ at time $t$ and time $t-\Delta t$. This means that historical measurements (i.e. measurements from at least one preceding time step) are used in the transient state estimator.

Note that the transient state estimation (TSE) algorithm above is based on a discretized state space model. However, it is impossible for current hardware to perform this TSE algorithm for every time step because the interval between sample measurements is the same as the interval between estimations. But, as described above, for the transient DSSE the interval between two estimation processes is the scanning cycle which is significantly larger (i.e. multiple time steps). This can actually reduce the hardware requirements for transmission of measured data and make it easier to implement the DSSE in practice.

4) The Transient State Estimations. In static state estimation, the estimated states contain the voltage magnitude and the phase angle. As aforementioned, the phasor is meaningless in transient conditions, so the instantaneous bus voltage ($v_i(t)$ and $v_j(t)$ in Figure 5) and the branch current $i_{ij}(t)$ are selected as the states for the transient DSSE estimation. At time $t$, the mathematical expression of the states is:

$$x(t) = \begin{bmatrix} v_i(t) & v_j(t) & i_{ij}(t) \end{bmatrix}^T \qquad (8)$$

The instantaneous measurements considered in the DSSE estimator include the bus voltages and currents of the sending-end and the receiving-end in a branch. The measurements can be described as,

$$z(t) = \begin{bmatrix} z_v(t) & z_{Ii}(t) & z_{Ij}(t) \end{bmatrix}^T \qquad (9)$$

where:

$z_v(t)$     is a vector of the voltage magnitude measurements;
$z_{Ii}(t)$     is a vector of the sending-end current measurements; and
$z_{Ij}(t)$     is a vector of the receiving-end current measurements.

The DSSE estimator receives the data of one synchronized measurement or PMU scanning cycle at the end of each cycle (i.e. one set of measurements is received per scanning cycle). For the synchronized measurements obtained at step 2) above, there are $n$ samples in one scanning cycle, as shown in Figure 4. Each sample corresponds to a time step in the estimation model. At each time step, there is a measurement model, which relates the measurements to the states in the scanning cycle. In other words, the estimation model is derived from from the measurement models in the scanning cycle. Hence, the transient DSSE estimator can estimate the states of $n$ time steps at one time.

This estimation model may be formulated using the following equations, which may be referred to as a transient state estimation with measurements of multiple steps.

$$\begin{bmatrix} z(t - n \cdot \Delta t) \\ z(t - (n-1) \cdot \Delta t) \\ \cdots \\ z(t - \Delta t) \\ z(t) \end{bmatrix} = \tilde{H} \cdot \begin{bmatrix} x(t - n \cdot \Delta t) \\ x(t - (n-1) \cdot \Delta t) \\ \cdots \\ x(t - \Delta t) \\ x(t) \end{bmatrix} + \tilde{e} \qquad (10)$$

$$\tilde{Z} = \tilde{H} \cdot \tilde{X} + \tilde{e} \qquad (11)$$

where:

$\tilde{H}$     is the measurement matrix;
$\tilde{e}$     is the error vector of measurements;

$\tilde{Z}$   is the instantaneous measurement vector in a scanning cycle; and
$\tilde{X}$   is the states vector in a scanning cycle.

The structure of the measurement matrix $\tilde{H}$ is illustrated in Figure 6. At each time step, the measurements would add a set of rows to the measurement matrix $\tilde{H}$. The measurements only associate with states at the previous time step and the current time step (as indicated in equations 5-7 above). As a result, the measurement matrix is very sparse (the symbol 'X' denotes non-zero entries in the matrix, and the others are zero entries). The entries of the measurement matrix $\tilde{H}$ are dependent on the network topology and the sampling rate of the PMU measurements. If both of them remain unchanged, the measurement matrix would be constant. In that case, $\tilde{H}$ only needs to be solved once. The results can be saved in the memory and utilized to perform DSSE estimation until the next change of network topology. Thus, the memory cost can be reduced and the computational efficiency is improved as well.

Moreover, as equations (5)-(7) are linear, the measurement matrix is also linear. The measurement model in equation (11) can be solved by a linear approach. Nevertheless, the amount of data exchange is increased by the higher sampling rate of the measurements, but this may be mitigated by the decomposition of the grid in step 1) and the distributed computing strategy.

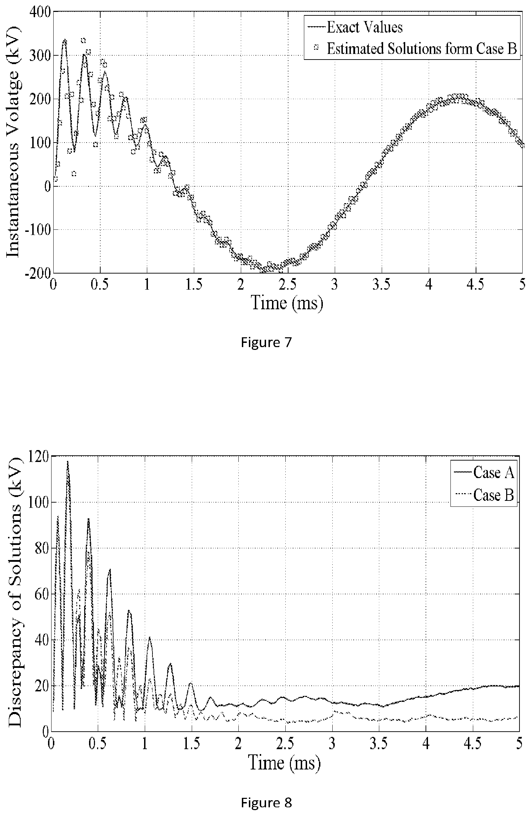

Figures 7 and 8 illustrate results from a test case carried on the IEEE 14-bus system shown in Figure 1. A transient condition caused by a three-phase grounded fault at Bus 5 was simulated using PSCAD/EMTDC (Power System Computer Aided Design/Electromagnetic Transients including DC). Case A uses the method proposed by Yu and Watson in "An Approximate Method for Transient State Estimation": IEEE Trans. Power Del., 2007. 22(3): pp 1680-1687, referred to above, and Case B uses the DSSE method described herein.

Figure 7 shows the estimated solutions using the DSSE method of the present invention and demonstrates the feasibility of the method. Figure 7 shows, point by point for each time step, the estimated results of the instantaneous voltage at Bus 5 during the disturbance, while the continuous line is the actual voltage. Although not perfect, the estimation accuracy is acceptable for most power grid applications, and is a significant improvement over other known methods that are used in practice.

Figure 8 shows the absolute discrepancies between the estimated values and the exact values of the voltage at Bus 5 for each of Cases A and B. This shows that the DSSE method (Case B) of the present invention has the higher estimation accuracy.

With some reasonable decomposition strategies, the DSSE method of the present invention can increase the estimation accuracy by up to 32%, and improve the computational efficiency by up to 24%, compared with the method proposed by Yu and Watson (Case A above). A further improvement in computational efficiency can be expected for larger power systems.

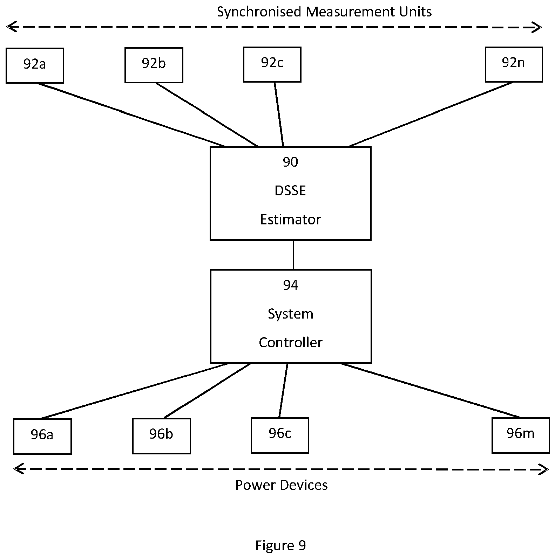

Figure 9 is a schematic illustration showing how the DSSE estimator 90 interfaces with components of a power system. As described above the power system has a number of synchronised measurement units (PMUs) 92a to 92n at various locations, and these are used to monitor the conditions (current and/or voltage) at those locations. The units 92a-92n provide data of all the sampled voltage/current measurements made for a complete scanning cycle to the DSSE estimator 90 after each scanning cycle. The DSSE estimator 90 analyses the data and provides state estimations, as described above, to a system control function 94. The system control function 94 controls operation of various power devices 96a - 96m, such as synchronous condensers, FACTS devices, and HVDC and/or HVDC Grid. The system control function 94 can make adjustments to the power flows in the power system through these power devices 96a-96m based on the state estimations provided by the DSSE estimator 90.

The following features affect the performance of the DSSE:

- The accuracy of synchronised measurements;

- The period of the scanning cycle, and the number of samples per scanning cycle determine the time interval time between two measurement steps - a higher estimation accuracy can be achieved with a smaller time interval;

- The decomposition strategy used to sub-divide a large system - if there are more subsystems being divided from the large system, the computational efficiency is higher, whilst the estimation accuracy is lower, resulting in a trade-off between the estimation accuracy and efficiency;

- The speed of communication between hardware components and the computational speed of estimator.

**Claims**

1. A method of controlling power flows and/or voltages in a power system (10), the method comprising:

monitoring conditions of voltage and/or current at a set of system locations for a scanning cycle of synchronised measurements comprising a series of time steps in which instantaneous sample measurements of voltage and/or current are taken, the monitoring providing data comprising the instantaneous sample measurements for a complete scanning cycle; wherein, at the end of each scanning cycle, the data comprising instantaneous sample measurements for multiple time steps of the complete scanning cycle is entered into a transient state estimation model comprising a set of equations;

determining a transient state estimation (104) by solving the set of equations, for two or more sequential time steps of the series of time steps, once for the scanning cycle, the transient state estimation of the scanning cycle based on the data for the two or more sequential time steps of the series of time steps, wherein the transient state estimation includes an estimation of a non-sinusoidal voltage or current waveform caused by a disturbance to the power system;

forming a snapshot that includes instantaneous voltages, current flows and power flows of the power system; and making an adjustment to mitigate the effect of the disturbance (106).

2. The method of claim 1, wherein the synchronised measurements are provided from several synchronised measurement units (92a- 92n), for example phasor measurement units, PMUs.

3. The method of claim 1 or claim 2, wherein determining the transient state estimation includes determining an estimation at system locations other than the system locations used for the monitoring.

4. The method of any preceding claim, wherein the synchronised measurements are obtained using a standard time signal as a reference, for example a Global Positioning System, GPS, time signal, and optionally wherein the transient state estimation employs the same time reference as the synchronised measurements using the standard time signal.

5. The method of any preceding claim, wherein the transient state estimation is based on a state space model and a discretised model that includes a non-sinusoidal voltage or current waveform in the estimation.

6. The method of any preceding claim, wherein the power system (10) comprises a plurality of interconnected buses, including one or more buses at which power can be supplied to the grid, and one or more buses at which power can be drawn from the grid, the method including adjusting and amount of power supplied to and/or drawn from one or more of the buses.

7. The method of claim 6 further comprising dividing the power system into a plurality of subsystems, each subsystem comprising one or more of said buses, wherein the monitoring comprises taking measurements from each of the subsystems, and wherein a transient state estimation is determined for each subsystem and optionally wherein a non-overlapping approach is used to divide the power system into the plurality of subsystems connected by tie-lines (14), the tie lines (14) comprising transmission lines or transformers.

8. The method of claim 6 or claim 7, wherein the transient state estimations of each of the subsystems are aggregated to provide a transient state estimation of the whole power system (10) and optionally wherein the aggregated transient state estimation provides the snapshot including voltages, current flows and power flows of the whole power system (10), or of part of the power system.

9. The method of any preceding claim, wherein the adjustment is an adjustment to an amount of power supplied to and/or drawn from the power system, and/or protecting the system (10) by changing the system configuration.

10. The method of any preceding claim further comprising using the snapshot data in control functions or FACTS devices or HVDC systems to protect and control the power system (10).

11. A power system (10) comprising

a plurality of synchronised measurement units (92a-92n) at locations in the power system (10), each measurement unit configured to obtain sample data over a synchronised scanning cycle comprising a series of time steps in which instantaneous sample measurements of voltages and/or currents are taken, and to transmit the instantaneous sample data for a complete scanning cycle after completion of the cycle; the system configured to at the end of each scanning cycle, enter the data comprising instantaneous sample measurements for multiple time steps of the complete scanning cycle into a transient state estimation model comprising a set of equations; a transient state estimator (90) configured to receive and analyse the sample data to determine a transient state estimation by solving the set of equations once for the multiple time steps of the scanning cycle, the transient state estimation of the scanning cycle based on the data comprising instantaneous sample measurements for the multiple time steps of the complete scanning cycle, wherein the transient state estimation includes an estimation of a non-sinusoidal voltage or current waveform caused by a disturbance to the power system (10); and at least one power device (96a-96m) for making an adjustment to mitigate the effect of the disturbance.

12. The power system (10) of claim 11, wherein the transient state estimator is configured to analyse the sample data to provide transient state estimations for each of a plurality of subsystems that make up the whole power system (10), or part of the power system (10), and optionally,

wherein the transient state estimator (90) is further configured to aggregate the transient state estimation for each of the subsystems to provide a transient state estimation for the whole power system (10), or part of the power system (10).

13. The power system (10) of any of claims 11 to 12, further comprising a system controller (94), the system controller (94) configured to receive the transient state estimations and to control said at least one power device (96a-96m) to mitigate the effect of the disturbance.

14. The power system (10) of any of claims 11 to 13, wherein the system provides an output to several control functions, such as frequency stability control, voltage stability control, transient stability control, system oscillations control, system component protection schemes, system wide automated protection schemes, and system integrity protection schemes (SIPS), or for use by FACTS devices and/or High Voltage DC (HVDC) and/or HVDC Grid to protect and control the power system (10).

15. The power system of claim 12 wherein one or more of the subsystems comprises one or more substations, each substation including one or more buses, power transformers, switching devices such as circuit breakers or disconnectors to cut power, and wherein measurement, protection and control devices are physically located in the substation.

## Patentansprüche

1. Verfahren zum Steuern von Energieflüssen und/oder Spannungen in einem Stromversorgungssystem (10), wobei das Verfahren Folgendes umfasst:

Überwachen von Zuständen von Spannung und/oder Strom an einer Reihe von Systemstandorten für einen Scanzyklus von synchronisierten Messungen, der eine Reihe von Zeitschritten umfasst, in denen momentane Probemessungen von Spannung und/oder Strom vorgenommen werden, wobei das Überwachen Daten bereitstellt, die die momentanen Probemessungen für einen vollständigen Scanzyklus umfassen; wobei am Ende jedes Scanzyklus die Daten, die momentane Probemessungen für mehrere Zeitschritte des vollständigen Scanzyklus umfassen, in ein Übergangszustandsschätzmodell, das einen Satz von Gleichungen umfasst, eingegeben werden;
Bestimmen einer Übergangszustandsschätzung (104) durch Auflösen des Satzes von Gleichungen für zwei oder mehr sequenzielle Zeitschritte der Reihe von Zeitschritten, einmal für den Scanzyklus, wobei die Übergangszustandsschätzung des Scanzyklus auf den Daten für die zwei oder mehr sequenziellen Zeitschritte der Reihe von Zeitschritten basiert, wobei die Übergangszustandsschätzung eine Schätzung einer nicht sinusförmigen Spannungs- oder Stromwellenform beinhaltet, wobei die Übergangszustandsschätzung eine Schätzung einer nicht sinusförmigen Spannungs- oder Stromwellenform beinhaltet, die durch eine Störung des Stromversorgungssystems verursacht wird;
Bilden eines Schnappschusses, der momentane Spannungen, Stromflüsse und Energieflüsse des Stromversorgungssystems beinhaltet; und
Vornehmen einer Anpassung, um den Effekt der Störung zu mindern (106).

2. Verfahren nach Anspruch 1, wobei die synchronisierten Messungen von mehreren synchronisierten Messeinheiten (92a bis 92n), beispielsweise Zeigermesseinheiten, PMUs, bereitgestellt werden.

3. Verfahren nach Anspruch 1 oder Anspruch 2, wobei das Bestimmen der Übergangszustandsschätzung das Bestimmen einer Schätzung an anderen Systemstandorten als den Systemstandorten, die für das Überwachen verwendet werden, beinhaltet.

4. Verfahren nach einem der vorhergehenden Ansprüche, wobei die synchronisierten Messungen unter Verwendung eines Standardzeitsignals als eine Referenz, beispielsweise des Zeitsignals eines globalen Positionsbestimmungssystems, GPS, erhalten werden und wahlweise wobei die Übergangszustandsschätzung dieselbe Zeitreferenz nutzt wie die synchronisierten Messungen, unter Anwendung des Standardzeitsignals.

5. Verfahren nach einem der vorhergehenden Ansprüche, wobei die Übergangszustandsschätzung auf einem Zustandsraummodell und einem diskretisierten Modell, das eine nicht sinusförmige Spannungs- oder Stromwellenform in der Schätzung beinhaltet, basiert.

6. Verfahren nach einem der vorhergehenden Ansprüche, wobei das Stromversorgungssystem (10) eine Vielzahl von miteinander verbundenen Bussen umfasst, die einen oder mehrere Busse, an denen Leistung in das Netz eingespeist werden kann, und einen oder mehrere Busse, an denen Leistung aus dem Netz entnommen werden kann, beinhalten, wobei das Verfahren das Anpassen einer Energiemenge, die in einen oder mehrere der Busse eingespeist und/oder aus diesen entnommen wird, beinhaltet.

7. Verfahren nach Anspruch 6, das ferner das Teilen des Stromversorgungssystems in eine Vielzahl von Untersystemen umfasst, wobei jedes Untersystem einen oder mehrere der Busse umfasst, wobei das Überwachen das Vornehmen von Messungen in jedem der Untersysteme umfasst und wobei eine Übergangszustandsschätzung für jedes Untersystem bestimmt wird und wahlweise wobei ein nicht überlappender Ansatz verwendet wird, um das Stromversorgungssystem in die Vielzahl von Untersystemen zu teilen, die durch Querverbindungsleitungen (14) verbunden sind, wobei die Querverbindungsleitungen (14) Übertragungsleitungen oder Transformatoren umfassen.

8. Verfahren nach Anspruch 6 oder Anspruch 7, wobei die Übergangszustandsschätzungen von jedem der Untersysteme aggregiert werden, um eine Übergangszustandsschätzung des gesamten Energiesystems (10) bereitzustellen, und wahlweise wobei die aggregierte Übergangszustandsschätzung den Schnappschuss bereitstellt, der Spannungen, Stromflüsse und Energieflüsse des gesamten Stromversorgungssystems (10) oder eines Teils des Stromversorgungssystems beinhaltet.

9. Verfahren nach einem der vorhergehenden Ansprüche, wobei die Anpassung eine Anpassung an eine Energiemenge, die in das Stromversorgungssystem eingespeist und/oder aus demselben entnommen wird, und/oder das Schützen des Systems (10) durch Ändern der Systemauslegung ist.

10. Verfahren nach einem der vorhergehenden Ansprüche, das ferner das Verwenden der Schnappschussdaten in Steuerfunktionen oder FACTS-Vorrichtungen oder HVDC-Systemen zum Schützen und Steuern des Stromversorgungssystems (10) umfasst.

11. Stromversorgungssystem (10), umfassend eine Vielzahl von synchronisierten Messeinheiten (92a bis 92n) an Standorten im Stromversorgungssystem (10), wobei jede Messeinheit dazu ausgelegt ist, Probedaten über einen synchronisierten Scanzyklus, der eine Reihe von Zeitschritten umfasst, in denen momentane Probemessungen von Spannungen und/oder Strömen vorgenommen werden, zu erhalten und die momentanen Probedaten für einen vollständigen Scanzyklus nach Abschluss des Zyklus zu übertragen;
wobei das System dazu ausgelegt ist, am Ende jedes Scanzyklus die Daten, die momentane Probemessungen für mehrere Zeitschritte des vollständigen Scanzyklus umfassen, in ein Übergangszustandsschätzmodell, das einen Satz von Gleichungen umfasst, einzugeben;
einen Übergangszustandsschätzer (90), der dazu ausgelegt ist, die Probedaten zu empfangen und zu analysieren, um durch Auflösen des Satzes von Gleichungen einmal für die mehreren Zeitschritte des Scanzyklus eine Übergangszustandsschätzung zu bestimmen, wobei die Übergangszustandsschätzung des Scanzyklus auf den Daten basiert, die momentane Probemessungen für die mehreren Zeitschritte des vollständigen Scanzyklus umfassen, wobei die Übergangszustandsschätzung eine Schätzung einer nicht sinusförmigen Spannungs- oder Stromwellenform beinhaltet, die durch eine Störung des Stromversorgungssystems (10) verursacht wird; und mindestens eine Stromversorgungsvorrichtung (96a bis 96m) zum Vornehmen einer Anpassung, um den Effekt der Störung zu mindern.

12. Stromversorgungssystem (10) nach Anspruch 11, wobei der Übergangszustandsschätzer dazu ausgelegt ist, die Probedaten zu analysieren, um Übergangszustandsschätzungen für jedes einer Vielzahl von Untersystemen, die das vollständige Stromversorgungssystem (10) bilden, oder einen Teil des Stromversorgungssystems (10) bereitzustellen, und wahlweise wobei der Übergangszustandsschätzer (90) ferner dazu ausgelegt ist, die Übergangszustandsschätzung für jedes der Untersysteme zu aggregieren, um für das vollständige Stromversorgungssystem (10) oder einen Teil des Stromversorgungssystems (10) eine Übergangszustandsschätzung bereitzustellen.

13. Energiesystem (10) nach einem der Ansprüche 11 bis 12, das ferner eine Systemsteuerung (94) umfasst, wobei die Systemsteuerung (94) dazu ausgelegt ist, die Übergangszustandsschätzungen zu empfangen und die mindestens eine Stromversorgungsvorrichtung (96a bis 96m) zu steuern, um den Effekt der Störung zu mindern.

14. Stromversorgungssystem (10) nach einem der Ansprüche 11 bis 13, wobei das System für mehrere Steuerfunktionen, wie etwa Frequenzstabilitätssteuerung, Spannungsstabilitätssteuerung, Übergangsstabilitätssteuerung, Systemoszillationssteuerung, Systemkomponentenschutzpläne, systemweite automatisierte Schutzpläne und Systemintegritätsschutzpläne (SIPS), oder zur Verwendung durch FACTS-Vorrichtungen und/oder DC-Hochspannung (HVDC) und/oder ein HVDC-Netz eine Ausgabe bereitstellt, um das Stromversorgungssystem (10) zu schützen und zu steuern.

15. Stromversorgungssystem nach Anspruch 12, wobei eines oder mehrere der Untersysteme eine oder mehrere Unterstationen umfassen, wobei jede Unterstation einen oder mehrere Busse, Energietransformatoren, Schaltvorrichtungen, wie etwa Energieschalter oder Trennschalter, um die Leistung zu trennen, beinhaltet und wobei sich Mess-, Schutz- und Steuervorrichtungen physisch in der Unterstation befinden.

## Revendications

1. Procédé pour commander des flux électriques et/ou des tensions dans un système électrique (10), le procédé comprenant :

la surveillance de conditions de tension et/ou de courant au niveau d'un ensemble d'emplacements du système pour un cycle de balayage de mesures synchronisées comprenant une série d'étapes temporelles dans lesquelles des mesures échantillons instantanées de tension et/ou de courant sont prises, la surveillance fournissant des données comprenant les mesures échantillons instantanées pour un cycle de balayage complet ; dans lequel, à la fin de chaque cycle de balayage, les données comprenant des mesures échantillons instantanées pour de multiples étapes temporelles du cycle de balayage complet sont entrées dans un modèle d'estimation d'état transitoire comprenant un ensemble d'équations ;
la détermination d'une estimation d'état transitoire (104) en résolvant l'ensemble d'équations, pour deux étapes temporelles séquentielles ou plus de la série des étapes temporelles, une fois pour le cycle de balayage, l'estimation de l'état transitoire du cycle de balayage étant basée sur les données pour les deux étapes temporelles séquentielles ou plus de la série des étapes temporelles, dans lequel l'estimation d'état transitoire inclut une estimation d'une forme d'onde de tension ou de courant non-sinusoïdale, dans lequel l'estimation d'état transitoire inclut une estimation d'une forme d'onde de tension ou de courant non-sinusoïdale provoquée par une perturbation du système électrique ;
la formation d'un instantané qui inclut des tensions, des flux de courant et des flux électriques instantanés du système électrique ; et
la réalisation d'un ajustement pour atténuer l'effet de la perturbation (106).

2. Procédé selon la revendication 1, dans lequel les mesures synchronisées sont fournies par plusieurs unités de mesure synchronisées (92a à 92n), par exemple des unités de mesure de phaseur (PMU).

3. Procédé selon la revendication 1 ou la revendication 2, dans lequel la détermination de l'estimation d'état transitoire inclut la détermination d'une estimation à des emplacements du système autres que les emplacements du système utilisés pour la surveillance.

4. Procédé selon l'une quelconque des revendications précédentes, dans lequel les mesures synchronisées sont obtenues en utilisant un signal de temps standard comme référence, par exemple le signal de temps d'un système de positionnement global, GPS, et optionnellement dans lequel l'estimation d'état transitoire emploie la même référence de temps que les mesures synchronisées en utilisant le signal de temps standard.

5. Procédé selon l'une quelconque des revendications précédentes, dans lequel l'estimation d'état transitoire est basée sur un modèle d'espace d'état et un modèle discrétisé qui inclut une forme d'onde de tension ou de courant non-sinusoïdale dans l'estimation.

**6.** Procédé selon l'une quelconque des revendications précédentes, dans lequel le système électrique (10) comprend une pluralité de bus interconnectés, incluant un ou plusieurs bus auxquels une alimentation peut être fournie au réseau, et un ou plusieurs bus dans lesquels une alimentation peut être tirée du réseau, le procédé incluant l'ajustement de la quantité de puissance fournie à et/ou tirée d'un ou plusieurs des bus.

**7.** Procédé selon la revendication 6, comprenant en outre la division du système électrique en une pluralité de sous-systèmes, chaque sous-système comprenant un ou plusieurs desdits bus, dans lequel la surveillance comprend la prise de mesures de chacun des sous-systèmes, et dans lequel une estimation d'état transitoire est déterminée pour chaque sous-système, et optionnellement dans lequel une approche non-chevauchante est utilisée pour diviser le système électrique en la pluralité de sous-systèmes raccordés par des lignes d'interconnexion (14), les lignes d'interconnexion (14) comprenant des lignes de transmission ou transformateurs.

**8.** Procédé selon la revendication 6 ou la revendication 7, dans lequel les estimations d'état transitoires de chacun des sous-systèmes sont agrégées pour fournir une estimation d'état transitoire de l'ensemble du système électrique (10), et optionnellement dans lequel l'estimation d'état transitoire agrégée fournit l'instantané incluant des tensions, des flux de courant et des flux électriques de l'ensemble du système électrique (10), ou d'une partie du système électrique.

**9.** Procédé selon l'une quelconque des revendications précédentes, dans lequel l'ajustement est un ajustement à une quantité d'alimentation fournie à et/ou tirée du système électrique, et/ou la protection du système (10) en modifiant la configuration du système.

**10.** Procédé selon l'une quelconque des revendications précédentes, comprenant en outre l'utilisation de données instantanées dans des fonctions de contrôle ou dispositifs FACTS ou systèmes HVDC permettant de protéger et de commander le système électrique (10).

**11.** Système électrique (10) comprenant une pluralité d'unités de mesure synchronisées (92a à 92n) à des emplacements dans le système électrique (10), chaque unité de mesure étant configurée pour obtenir des données échantillons sur un cycle de balayage synchronisé comprenant une série d'étapes temporelles, dans lesquelles des mesures échantillons instantanées de tensions et/ou courants sont prises, et pour transmettre les données échantillons instantanées pour un cycle de balayage complet après achèvement du cycle ;
le système étant configuré, à la fin de chaque cycle de balayage, pour entrer les données comprenant des mesures échantillons instantanées pour de multiples étapes temporelles du cycle de balayage complet dans un modèle d'estimation d'état transitoire comprenant un ensemble d'équations ;
un estimateur d'état transitoire (90) configuré pour recevoir et analyser les données échantillons pour déterminer une estimation d'état transitoire en résolvant l'ensemble d'équations une fois pour les multiples étapes temporelles du cycle de balayage, l'estimation d'état transitoire du cycle de balayage étant basée sur les données comprenant des mesures échantillons instantanées pour les multiples étapes temporelles du cycle de balayage complet, dans lequel l'estimation d'état transitoire inclut une estimation d'une forme d'onde de tension ou de courant non-sinusoïdale provoquée par une perturbation du système électrique (10) ; et au moins un dispositif électrique (96a à 96m) pour réaliser un ajustement pour atténuer l'effet de la perturbation.

**12.** Système électrique (10) selon la revendication 11, dans lequel l'estimateur d'état transitoire est configuré pour analyser les données échantillons pour fournir des estimations d'état transitoire pour chacun d'une pluralité de sous-systèmes, qui constituent l'ensemble du système électrique (10), ou une partie du système électrique (10), et optionnellement, dans lequel l'estimateur d'état transitoire (90) est en outre configuré pour agréger l'estimation d'état transitoire pour chacun des sous-systèmes, pour fournir une estimation d'état transitoire pour l'ensemble du système électrique (10), ou une partie du système électrique (10).

**13.** Système électrique (10) selon l'une quelconque des revendications 11 à 12, comprenant en outre un dispositif de commande du système (94), le dispositif de commande du système (94) étant configuré pour recevoir les estimations d'état transitoire et pour commander ledit au moins un dispositif électrique (96a à 96m) pour atténuer l'effet de la perturbation.

**14.** Système électrique (10) selon l'une quelconque des revendications 11 à 13, dans lequel le système fournit une sortie à plusieurs fonctions de contrôle, comme un contrôle de la stabilité de fréquence, un contrôle de la stabilité de tension, un contrôle de la stabilité transitoire, un contrôle des oscillations du système, des programmes de protection du composant du système, des programmes de protection automatisés à l'échelle du système, et des programmes de protection de l'intégrité du système (SIPS), ou pour une utilisation par des dispositifs FACTS et/ou DC haute tension (HVDC) et/ou un réseau HVDC permettant de protéger et de commander le système électrique (10).

15. Système électrique selon la revendication 12, dans lequel un ou plusieurs des sous-systèmes comprennent une ou plusieurs sous-stations, chaque sous-station incluant un ou plusieurs bus, transformateurs électriques, dispositifs de commutation comme des interrupteurs ou des disjoncteurs permettant de couper le courant, et dans lequel des dispositifs de mesure, de protection et de commande sont physiquement situés dans la sous-station.

Figure 1

Figure 2

Phasor Measurement Unit (PMU)

Raw
Samples

Filters → Sampled Data → Phasor Estimator →

Phasor
Measurements

Figure 3

Raw
Samples

Scanning
Cycle

t

Figure 4

Figure 5

Figure 6

Figure 7

Figure 8

Synchronised Measurement Units

| 92a | | 92b | | 92c | | | 92n |

90

DSSE

Estimator

94

System

Controller

| 96a | | 96b | | 96c | | | 96m |

Power Devices

Figure 9

```
┌──────────────────────────────────────────────────────────┐
│ 100 Decompose system into a plurality of small subsystems │
└──────────────────────────────────────────────────────────┘
                             │
                             ▼
┌──────────────────────────────────────────────────────────┐
│ 102 In each subsystem obtain synchronised measurements    │
│ for a scanning cycle and provided these to estimator at the│
│ end of the scanning cycle                                  │
└──────────────────────────────────────────────────────────┘
                             │
                             ▼
┌──────────────────────────────────────────────────────────┐
│ 103 Perform estimations with model that uses non-sinusoidal│
│ voltage and current waveforms                             │
└──────────────────────────────────────────────────────────┘
                             │
                             ▼
┌──────────────────────────────────────────────────────────┐
│ 104 Determine transient state estimations for each of the │
│ subsystems during the period of the disturbance           │
└──────────────────────────────────────────────────────────┘
                             │
                             ▼
┌──────────────────────────────────────────────────────────┐
│ 105 Aggregate all the subsystem estimations to provide a  │
│ transient state estimation of the whole power grid during the│
│ disturbance                                               │
└──────────────────────────────────────────────────────────┘
                             │
                             ▼
┌──────────────────────────────────────────────────────────┐
│ 106 Use the estimations for system protection and control │
│ during the disturbance                                    │
└──────────────────────────────────────────────────────────┘
```

Figure 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZIMA-BOCKARJOVA et al.** Analysis of the State Estimation Performance in Transient Conditions. *IEEE Trans. Power Syst,* 2011, vol. 26 (4), 1866-1874
- **YU ; WATSON.** An Approximate Method for Transient State Estimation. *IEEE Trans. Power Del.,* 2007, vol. 22 (3), 1680-1687
- Object-oriented 3-Phase distributed dynamic state estimator. **RENKE HUANG et al.** POWER AND ENERGY SOCIETY GENERAL MEETING, 2011 IEEE. IEEE, 24 July 2011, 1-8
- **GOMEZ-EXPOSITO.** A taxonomy of multi-area state estimation methods. *Electric Power Systems Research,* 2011, vol. 81, 1060-1069